# EUROPEAN PATENT SPECIFICATION

(11) **EP 3 665 715 B1**
(45) Date of publication and mention of the grant of the patent: **11.01.2023**
(21) Application number: 18843771.9
(22) Date of filing: 08.08.2018
(51) Int. Cl.: H01J 37/32, C23C 16/27, C23C 16/455

(54) **MICROWAVE REACTOR FOR DEPOSITION OR TREATMENT OF CARBON COMPOUNDS**
MIKROWELLENREAKTOR ZUR ABSCHEIDUNG ODER BEHANDLUNG VON KOHLENSTOFFVERBINDUNGEN
RÉACTEUR À MICRO-ONDES POUR LE DÉPÔT OU LE TRAITEMENT DE COMPOSÉS CARBONÉS

(30) Priority: 10.08.2017 US 201762543914 P; 24.01.2018 US 201815879371
(43) Date of publication of application: 17.06.2020
(73) Proprietor: Applied Materials, Inc., Santa Clara, CA 95054 (US)
(72) Inventor: LIANG, Qiwei, Fremont California 94536 (US); ZHOU, Jie, San Jose California 95132 (US); KHAN, Adib M., Cupertino California 95014 (US); PISHARODY, Gautam, Newark California 94560 (US); CHEN, Guannan, San Carlos California 94070 (US); YING, Chentsau, Cupertino California 95014 (US); NEMANI, Srinivas D., Sunnyvale California 94087 (US)
(74) Representative: Zimmermann & Partner Patentanwälte mbB
(86) International application number: PCT/US2018/045820
(87) International publication number: WO 2019/032708

(56) References cited:
- EP-A2- 0 382 065
- US-A- 5 427 827
- US-A1- 2004 038 551
- US-A1- 2008 286 982
- US-A1- 2010 307 684
- US-A1- 2015 351 166
- US-A1- 2015 351 166
- US-A1- 2015 376 788
- US-A1- 2016 196 955
- US-A1- 2016 196 955
- US-B1- 6 190 458

## Description

### BACKGROUND

### Technical Field:

The disclosure concerns a chamber or reactor for processing a workpiece such as a semiconductor wafer using microwave power.

### Background Discussion

Processing of a workpiece such as a semiconductor wafer can be carried out using a form of electromagnetic energy, such as RF power or microwave power, for example. The power may be employed, for example, to generate a plasma, for carrying out a plasma-based process such as plasma enhanced chemical vapor deposition (PECVD) or plasma enhanced reactive ion etching (PERIE). For example, US 2016/0196955 A1 describes a microwave antenna including a first spiral conduit having a first conduit end, first plural ports in a floor of the first spiral conduit spaced apart along the length of the first spiral conduit; an axial conduit coupled to a rotatable stage; and a distributor waveguide comprising an input coupled to the axial conduit and a first output coupled to the first conduit end. Further exemplarily, US 2015/0351166 A1 describes a chamber or reactor for processing a workpiece such as a semiconductor wafer using microwave power. Further exemplarily, US 5,427,827 describes film deposition processes and systems, e.g. a diamond-like film deposition process and system. Further exemplarily, EP 0382065 A2 describes a plasma processing apparatus including a microwave generator, a waveguide for supplying microwaves generated by the microwave generator, a cavity resonator for resonating the microwaves supplied by the waveguide, and a plasma processing chamber. As a further example, US 6,190,458 B1 describes an impurity eliminating apparatus for eliminating impurities on a surface of a substrate, a film forming apparatus, and a film forming method.

Two carbon-based films, namely diamond and graphene, have mechanical and electrical properties that are desirable for many applications.

Diamond films can have extreme hardness, high thermal conductivity, good optical transparency and high electrical resistivity. These properties are useful in applications such as optical coatings. In addition, a diamond film can also be used as a hard mask material in the semiconductor industry due to its superior etch selectivity compared with other amorphous carbon films deposited by traditional PECVD. The etch selectivity of diamond can be two or three times higher than other amorphous carbon films due to a high sp3 carbon percentage. This high etch selectivity is desirable for a high aspect ratio etch in order to maintain good pattern integrity during high ion energy bombardment etch. This is likely to become more critical as feature sizes continue to shrink for next generation devices.

A monolayer of graphene, in which a single atomic layer of carbon atoms are arranged in a hexagonal lattice, has exotic properties and a wide spectrum of potential applications. The high specific surface area of graphene indicates that graphene is likely able to store more energy than other carbonaceous materials. In addition, delocalized electrons in a graphene sheet that travel in high speed with intrinsic mobility of ~2 - 2.5 × 10⁵ cm²/vs, help to transport current efficiently. Due to its thin thickness and high electron mobility, graphene can be used to replace the traditional metal barrier layers for next generation semiconductor devices because the resistance of metal lines gets higher as their thickness and dimension continues to shrink. Graphene also demonstrates high optical transparency, which can be used in flexible electronics, for example in smart watch applications. Chemical vapor deposition (CVD) has been used to grow both diamond and graphene films.

### SUMMARY

In one aspect, a plasma reactor for processing a workpiece according to claim 1 is provided. The plasma reactor can include a chamber having a dielectric window, a workpiece support to hold a workpiece in the chamber, a rotary coupling including a stationary stage configured to be coupled to a microwave source and a rotatable stage having an axis of rotation, a microwave antenna overlying the dielectric window of the chamber, a rotary actuator to rotate the microwave antenna, and a process gas distributor including a gas distribution ring surrounding the workpiece support. The microwave antenna includes at least one conduit coupled to the rotatable stage. The gas distribution ring including a cylindrical chamber liner separating a circular conduit from the chamber and a plurality of apertures extending radially through the liner to connect the conduit to the chamber.

In another aspect, a plasma reactor for processing a workpiece includes a chamber having a dielectric window, a workpiece support to hold a workpiece in the chamber, a rotary coupling including a stationary stage configured to be coupled to a microwave source and a rotatable stage having an axis of rotation, a microwave antenna overlying the dielectric window of the chamber, a rotary actuator to rotate the microwave antenna, a first gas supply to provide a hydrocarbon gas, a second gas supply to provide an inert gas, a gas distributor to deliver the hydrocarbon gas and the inert gas to the chamber, a vacuum pump coupled to the chamber to evacuate the chamber, and a controller configured to operate the microwave source, gas distributor and vacuum pump to deposit a carbon allotrope on the workpiece. Yet in another aspect, a method of processing a workpiece according to claim 12 is provided.

High quality graphene films are normally synthesized by high temperature chemical vapor deposition (CVD) with metal catalysts. However, the growth temperature is 800-1100° C, which is much higher than the thermal budget of most semiconductor devices. Moreover, a transfer process from metal substrates to targeted substrates is needed in order to incorporate the graphene into electronic devices. In this disclosure, microwave surface wave plasma provides high density of active radicals, which facilitates graphene nucleation and growth at much lower temperature (e.g., less than 800° C) without using metal catalysts. The direct growth on arbitrary substrates at lower temperature can be a significant advantage for a variety of applications.

Some implementations may provide one or more of the following advantages. Microwave plasma processing can provide low temperature deposition because of its high radical density and low energy. Microwave plasma processing can provide not only high density of hydrocarbon species for fast deposition, but also high density of hydrogen radicals, which can etch away amorphous carbon phase at much lower process temperature. As a result, fast deposition of high quality films can be achieved at reduced process temperatures. Therefore, microwave plasma-based deposition, can yield high quality diamond and graphene films on both dielectric and metal substrates suitable for high-volume manufacturing.

The details of one or more implementations are set forth in the accompanying drawings and the description below. Other potential features, aspects, and advantages will become apparent from the description, the drawings, and the claims.

### BRIEF DESCRIPTION OF THE DRAWINGS

FIG. 1A is schematic cross-sectional side view of a processing reactor.
FIG. 1B is a schematic enlarged view of a microwave antenna from the reactor of FIG. 1A.
FIG. 2 is a schematic cross-sectional plan taken along line 2-2 of FIG. 1B.
FIG. 3 is a schematic plan view of the embodiment of the microwave antenna.
FIG. 4 is a schematic cross-sectional perspective view of the microwave antenna.
FIGS. 5A and 5B are schematic side views of a gas distribution plate.
FIGS. 6A and 6B are a schematic plan views of a gas distribution ring.

Like reference numbers and designations in the various drawings indicate like elements.

It is contemplated that elements and features of one embodiment may be beneficially incorporated in other embodiments without further recitation. It is to be noted, however, that the drawings illustrate only exemplary embodiments of this invention and are therefore not to be considered limiting of its scope, for the invention may admit to other equally effective embodiments.

### DETAILED DESCRIPTION

Although diamond and graphene films have been deposited by CVD growth, such processes require high growth temperatures, typically 800-1000° C. Unfortunately, such temperatures are not compatible with current integration process flows in the semiconductor industry because the metal lines and low k films on device wafers can not tolerate the high temperature. In addition, graphene deposited by high temperature CVD needs to be transferred off of a thick metal foil on which it is deposited.

In addition, the quality of carbon compound materials can be improved by processing with extremely high density but non-equilibrium plasmas. A microwave reactor can provide both the low temperature and the high density, non-equilibrium plasma needed for high quality diamond and graphene films.

However, even with a rotating source to compensate for non-uniformity in the microwave emission caused by the chamber and slot layout, some microwave reactors do not meet the stringent uniformity required for distribution across the workpiece of deposition rate or etch rate. The minimum uniformity may correspond to a process rate variation across a 300 mm diameter workpiece of less than 1%.

Unfortunately, for some reactors or processes, a showerhead can not be used to deposition that inside the showerhead. However, the pumping liner can be used for skew of the pumping port flow. Process uniformity can further be controlled by adjusting the pedestal position and process pressure.

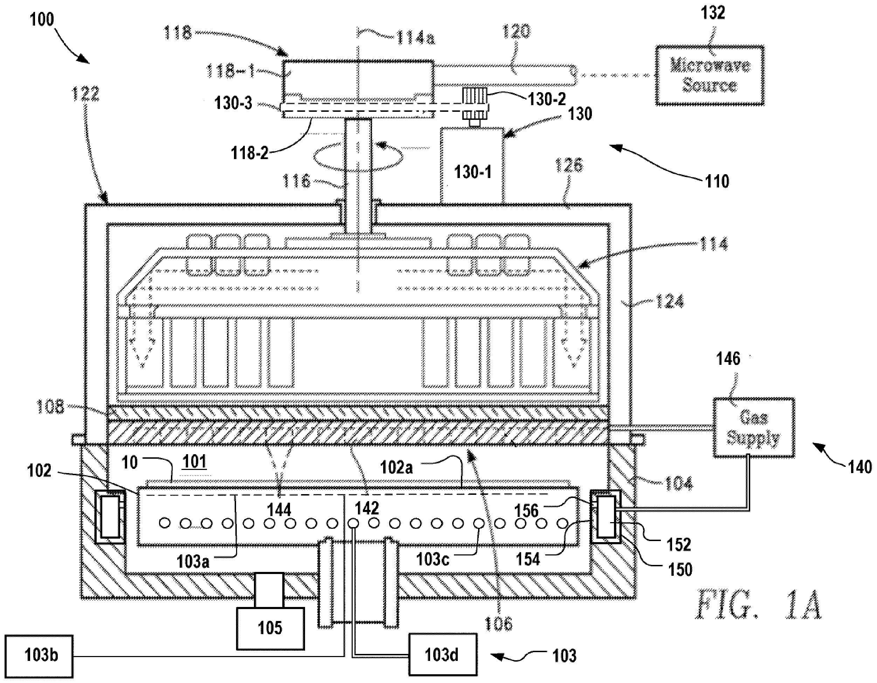

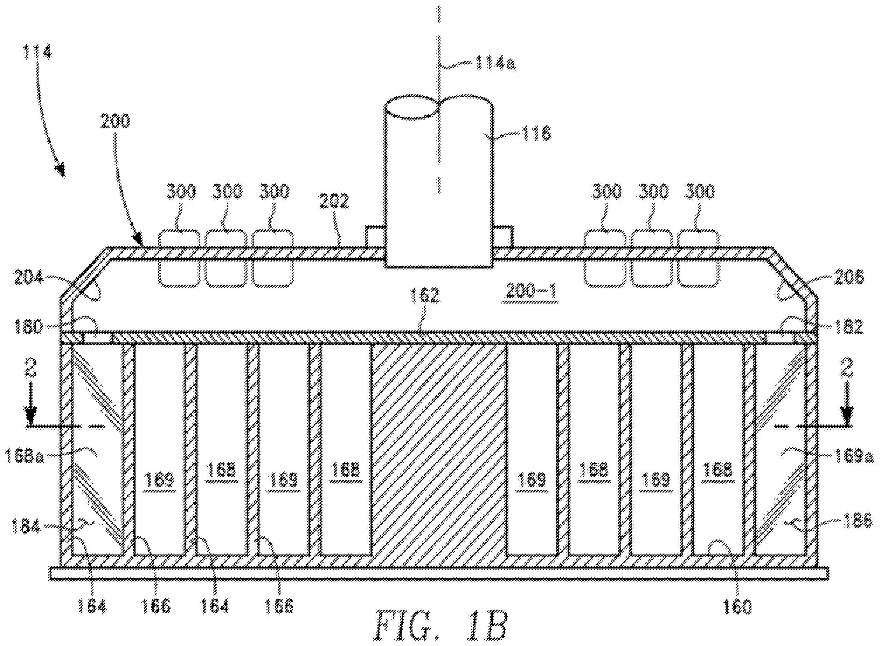

Referring now to FIGS. 1A and 1B, a workpiece processing reactor 100 includes a chamber 101 containing a workpiece support 102. The chamber 101 is enclosed by a side wall 104 formed of a material that is opaque to microwaves, e.g., a conductor, and a ceiling 106 formed of a microwave transparent material, e.g., a dielectric material. In one embodiment, the ceiling 106 may be implemented as a dielectric window 108 formed in the shape of a disk. The dielectric window 108 can fluidically seal the region above the window with the microwave supply assembly 110 from the chamber 101. In some implementations, the dielectric window 108 includes perforations. For example, the gas distribution plate 142 can form part of the window 108 (in which case the perforations extend partially into the window).

The workpiece support 102 can be a pedestal with a top surface 102a to support a workpiece 10 inside the chamber 101. In some implementations, a temperature control system 103 can control the temperature of the pedestal. For example, the temperature control system 103 can include a resistive heater 103a embedded in or placed on the surface of the workpiece support 102 and a power source 103b electrically coupled to the heater 103a. Alternatively or in addition, coolant channels 103c can be formed in the pedestal, and coolant from a coolant supply 103d can flow, e.g., be pumped, through the channels 103c.

In some implementations, the workpiece support 102 is coupled to a motor and is rotatable inside the chamber 101 by the motor. In some implementations, the vertical position of the workpiece support 102 is adjustable, e.g., by a vertical actuator.

A vacuum pump 105 is coupled to the chamber 101, e.g., by a passage with an opening in a region below the pedestal 102, to evacuate the chamber 101. Examples of vacuum pumps include an exhaust pump with throttle valve or isolation valve, dry pump and turbo pump.

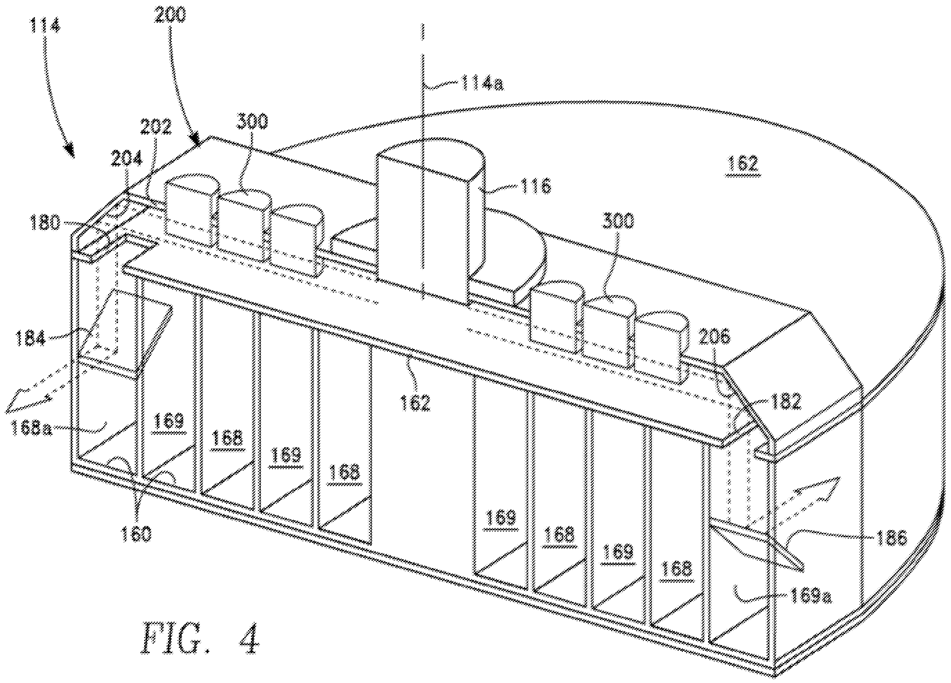

A microwave supply assembly 110 supplies microwave radiation to the chamber 100. The microwave supply assembly 110 includes a rotating microwave antenna 114 that overlies the dielectric window 108. The antenna 114 can rotate while the window 108 remains stationary; the antenna 114 could be slightly separated from the window 108 or in sliding contact with the window 108. The microwave antenna 114 is enclosed by a conductive shield 122 that includes a cylindrical side wall 124 and a disk-shaped cap 126. In an implementation depicted in FIG. 4, the microwave antenna 114 is disk-shaped.

As shown in FIG. 1A, the microwave antenna 114 is fed by an axial waveguide 116. The axial waveguide 116 is coupled through an overlying rotary microwave coupling 118 to a stationary microwave feed 120. A remote microwave source or generator 132 is coupled to the rotary coupling 118 by the microwave feed 120.

The rotary coupling 118 includes a stationary stage 118-1 and a rotatable stage 118-2. The stationary stage 118-1 is stationary relative to the chamber 100 and is connected to the microwave feed 120. The rotatable stage 118-2 is connected to the axial waveguide 116 and has an axis of rotation coinciding with an axis of symmetry 114a of the microwave antenna 114. The rotary microwave coupling 118 permits microwave energy to flow from the stationary stage 118-1 to the rotatable stage 118-2 with negligible loss or leakage. As one possible example, a slip-ring RF seal (not shown) may be placed at the interface between the stationary and rotatable stages 118-1 and 118-2. The antenna 114, rotary coupling 118 and axial waveguide 116 can provide the microwave supply assembly 110.

A rotatory actuator 130 is stationary relative to the chamber 101 and includes a motor 130-1. In some implementations, the rotatory actuator 130 includes a drive shaft 130-2 that drives a belt 130-3. The belt 130-3 is wound around a rotatable portion of the microwave supply assembly 110, so that driving the belt 130-3 rotates the antenna 114. For example, the belt 130-3 can be wound around and drive the rotatable stage 118-2. The belt 130-2 can be a toothed belt, and can engaged toothed outer surfaces of the drive shaft from the motor 130-1 and the rotatable stage 118-2. In other implementations, the toothed outer surface of the drive gear 130-2 directly engages a driven gear formed on the rotatable assembly 118-2. For example, the driven gear can be implemented as a circular array of teeth on the bottom surface of the rotatable stage 118-2.

The workpiece processing reactor 100 includes a process gas distributor 140.

In some implementations, the process gas distributor 140 includes a gas distribution plate (GDP) 142 disposed beneath or forming the ceiling 106. The gas distribution plate 142 has an array of gas injection orifices 144 extending axially through it. The gas distribution plate 142 receives process gas from a process gas supply 146. The gas distribution plate may be formed of quartz.

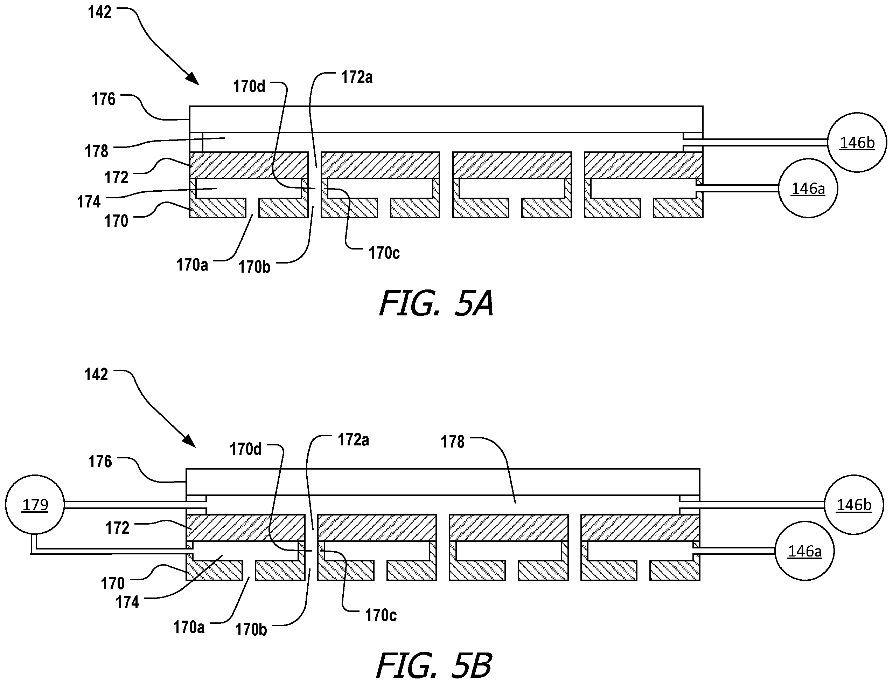

Referring to FIG. 5A, in some implementations, the gas distribution plate 142 is a dual channel showerhead configured to supply two different process gasses. For example, the gas distribution plate can include a lower plate 170 through which a plurality of axial apertures 170a and 170b are formed. The gas distribution plate can also include a middle plate 172 through which a plurality of axial apertures 172a are formed. The middle plate 172 extends over the lower plate 170, and the gap between the lower plate 170 and the middle plate 172 provides a lower plenum 174 into which a first process gas can flow from a first process gas supply 146a. This first process gas can then flow through a first plurality of apertures 170a into the chamber 101.

An upper plate 176 can extends over the middle plate 170, and the gap between the middle plate 172 and the upper plate 176 provides an upper plenum 176 into which a second process gas can flow from a second process gas supply 146b. The upper plate can be provided by the dielectric window 108, e.g., a quartz window.

Either the lower plate 170 or the middle plate 172, or both, can include annular projections 170c that extend axially from the main body of respective plate through the lower plenum 174. A plurality of apertures 170d are formed through the annular projections 170c, and the apertures 170b, 170d, 172a are aligned such that the second process gas can then flow from the upper plenum 178 through the apertures into the chamber 101. As such, the first and second processes gasses do not mix until inside the chamber 101.

Referring to FIG. 5B, in some implementations, the lower plenum 174, the upper plenum 178, or both are connected to a pump 179 that draws the first or second process gas through the respective plenum 174 or 178. This generates a cross-flow of gas through the plenum; a portion of the gas will escape through the apertures into the chamber 101.

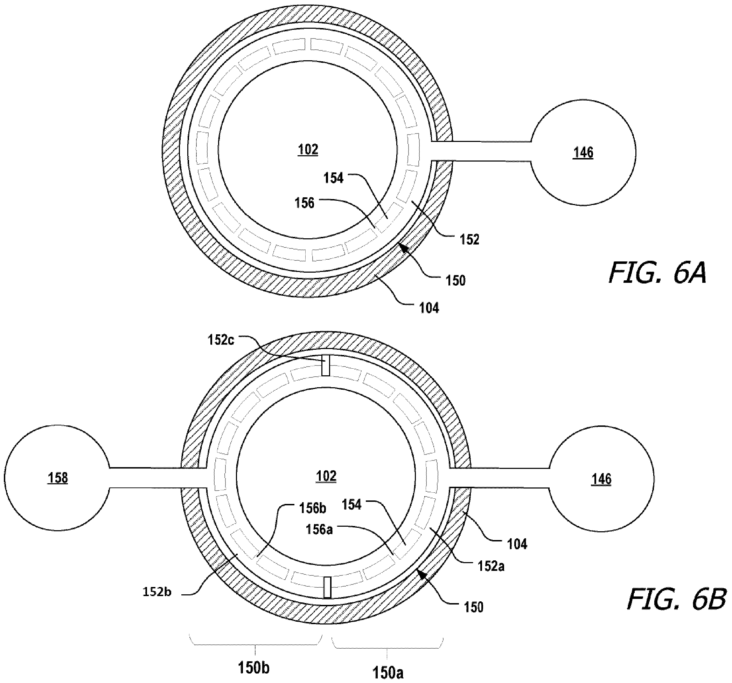

The process gas distributor 140 can also include a gas distribution ring 150 that surrounds the workpiece support 102. Referring to FIGS. 1A and 6A, the gas distribution ring 150 can include a channel 152 having an inner wall 154 that provides a liner for the chamber 101. The gas distribution ring 150 receives process gas from the process gas supply 146. A plurality of apertures 156, e.g., six to one-hundred apertures, are formed radially through the inner wall 154. The apertures 156 can be arranged with uniform angular spacing around the axis of symmetry 114a, thus providing angularly uniform gas flow into the chamber 101. In some implementations, the apertures 156 all have the same size and shape. In some implementations, the apertures 156 are positioned below a plane defined by the top surface 102a of the workpiece support 102 on which the workpiece will rest. In some implementations, no gas distribution plate is used; the process gas distributor 140 only injects gas from the side walls of the chamber 140. The gas distribution ring 150 and liner can be made from aluminum (e.g., anodized aluminum) or a ceramic material.

Referring to FIG. 6B, in some implementations, the gas distribution ring 150 is divided into two radial arcs 150a, 150b. A first channel 152a in the first radial arc 150a is connected to the process gas source 146. A second channel 152b in the second arc 150b is connected to a vacuum pump 158. The first channel 152a and the second channel 152b can be separated by a barrier 152c. Thus the process gas must exit from the first channel 152a into the chamber 101 before being drawn into the second channel 152b. The two radial arcs 150a, 150b can have substantially the same arc length, and are positioned on opposite sides of the axis of symmetry 114a.

The apertures 156 can be positioned slightly above a plane defined by the top surface 102a of the workpiece support 102 on which the workpiece will rest. The process gas emerges from the apertures 156a in the first radial arc 150a and is drawn into the apertures 156b in the second radial arc 150b, thus creating a cross-flow of the process gas across the workpiece 10 on the workpiece support 102.

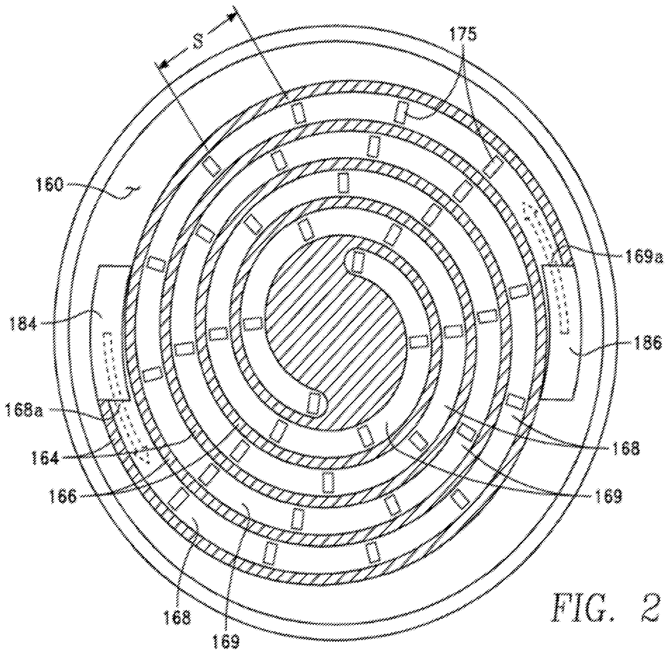

The microwave antenna 114 is depicted in detail in FIGS. 1B through 4, and includes an antenna floor 160, an antenna ceiling 162, and a pair parallel spiral waveguide side walls 164, 166 extending between the floor 160 and the ceiling 162. The pair of parallel spiral waveguide side walls 164, 166 form a pair of parallel spiral waveguide cavities 168, 169. In the illustrated embodiment, the pair of parallel spiral waveguide cavities 168, 169 form spirals of Archimedes, in which the radius of each spiral increases with the angle of rotation.

Small slots 175, or openings through the antenna floor 160, serve as microwave radiation ports and are disposed at locations periodically spaced along the length of each spiral waveguide cavity 168, 169. The slots 175 may be of any suitable shape and have an opening size, in one embodiment, a small fraction (e.g., one tenth or less) of a wavelength of the microwave generator 132. In one embodiment, the distance S between neighboring slots 175 along the length of each spiral conduit 168, 169 is a fraction (e.g., about one-half) of a wavelength of the microwave source 132. Microwave energy radiates through the slots 175 into the chamber 100.

A pair of feed openings 180, 182 in the ceiling 162 are disposed on opposing sides of the axis of symmetry 114a and provide respective paths for microwave energy to be fed into respective peripheral (radially outward) open ends 168a, 169a of the spiral waveguide cavities 168, 169. The peripheral open ends 168a, 169a are displaced from one another by an angle of 180 degrees along the periphery of the microwave antenna 114. Likewise, the pair of feed openings 180, 182 are displaced from one another by an angle of 180 degrees along the periphery of the microwave antenna 114.

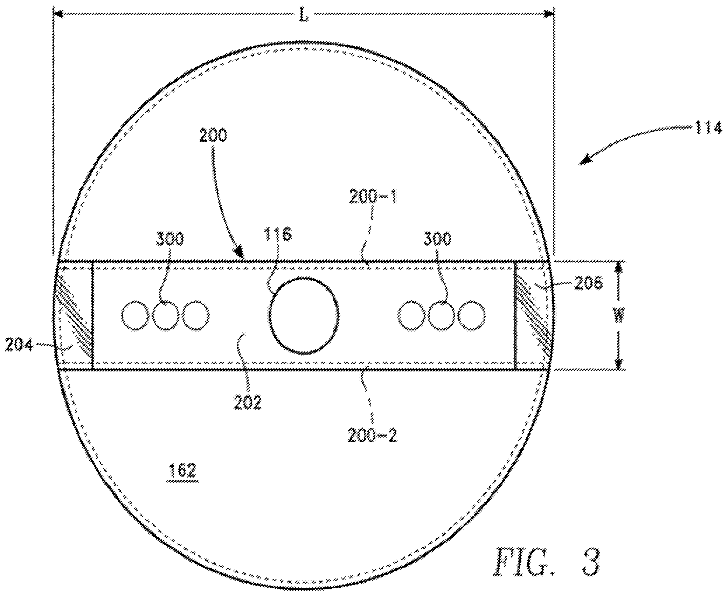

A distributor waveguide 200 depicted in FIGS. 3 and 4 overlies the ceiling 162 and distributes microwave energy from the axial waveguide 116 to the pair of feed openings 180, 182. The distributor waveguide 200 includes a waveguide top 202 overlying and facing the ceiling 162 and a pair of slanted end walls 204, 206 extending between the waveguide top 202 and the ceiling 162. The pair of slanted end walls 204, 206 reflect microwave energy flowing radially within the distributor waveguide 200 to flow axially into the feed openings 180, 182 respectively. A first slanted reflector surface 184 in registration with the feed opening 180 is disposed at an angle (e.g., 45 degrees) relative to the axis of symmetry 114a. A second slanted reflector surface 186 in registration with the feed opening 182 is disposed at an angle (e.g., 45 degrees) relative to the axis of symmetry 114a. The first and second slanted reflector surfaces 184, 186 reflect microwave energy flowing axially from the feed openings 180, 182 to flow azimuthally through the spiral waveguide cavities 168, 169 respectively. In one embodiment, the length of each of the slanted surfaces 184, 186, 204, 206 along the direction of wave propagation is one-quarter wavelength of the microwave generator 132. The slanted surfaces 184, 186, 204, 206 may be referred to as reflective surfaces.

Referring to FIG. 3, the distributor waveguide 200 has a length L corresponding to the diameter of the chamber 100, and a width W of several inches, in one embodiment. Axial flat side walls 200-1, 200-2 along the length L enclose the interior of the distributor waveguide 200. The height of the side walls 200-1, 200-2 corresponds to the distance between the ceiling 162 and the waveguide top 202. In one embodiment, this distance may be on the order one or a few inches. Optionally, plural microwave stub tuners 300 are placed at periodic locations along the length of the distributor waveguide 200.

An advantage of the embodiments of FIGS. 1B-4 is that microwave energy is uniformly distributed along the lengths of each spiral waveguide cavity 168, 169, so as to radiate in uniformly distributed intervals corresponding to the periodic locations of the slots 175. A further advantage is that power distribution among the pair of spiral waveguide cavities 168, 169 can be balanced by adjustment of the plural stub tuners 300.

### Deposition of Diamond or Graphene

The plasma reactor 100 can be employed to perform deposition of a carbon compound, for example a carbon allotrope, e.g., diamond or graphene. In one example, the workpiece 10 includes a patterned dielectric layer (e.g., silicon oxide) onto which a film of the carbon allotrope is to be deposited. For example, a possible application is to use a thin graphene layer to replace the tungsten layer in bitlines because the resistance of thin metal layer increases significantly as metal thickness drops, whereas a thin graphene layer can still show high electrical mobility.

In a process for deposition of the carbon allotrope, a feedstock gas is supplied to the chamber 100 by a process gas distributor 140. The feedstock gas includes at least a hydrocarbon compound, e.g., CH₄, C₂H₂, C₂H₄, or C₃H₆, etc.

An inert gas, e.g., argon or helium, can also be supplied to the chamber 100. The inert gas can be used to dilute the feedstock gas; this can increase plasma density. The gas supply 146 can establish a total pressure (feedstock and inert gas) of 20mTorr to 20Torr. The ratio of inert gas to feedstock gas can range from 1:20 to 20:1, e.g., 20:1 to 1:1.

The inert gas can be mixed with the feedstock gas before being delivered into the chamber 100, or the inert gas could be delivered by separate nozzles and mix in the chamber. In some implementations, the inert gas is supplied through the gas distribution plate 142 and the feedstock gas is supplied through the gas distribution ring 150. In some implementations, the inert gas is supplied through the gas distribution ring 150 and the feedstock gas is supplied through the gas distribution plate 142.

The microwave source 132 supplies microwave power at a frequency of 915 MHz to 2.45 GHz, e.g., 2.45 GHz. The microwave source 132 can apply 2 kW to 15 kW, e.g., 15 kW, of continuous power, or 8 kW to 50 kW, e.g., 50 kW, of pulsing power. The pulses of the pulsing power have a frequency of 10 Hz to 2500 Hz and duty cycle of 10% to 100%, e.g., 50%.

Application of the microwave power at appropriate frequency and power will ignite plasma in the chamber 100. The mere presence of the plasma will generate some carbon ions and radicals (as well as ions and radicals of the inert gas), which can be deposited on the workpiece to grow the layer of carbon compound. A microwave plasma can generate a high density of hydrogen radicals, which can etch away loose connected hydrocarbons and sp2 carbon to favor of high percentage of sp3 diamond phase growth. For diamond growth, diamond seeds can be prepared on surface before the deposition process in order to facilitate growth from seeds.

Without being limited to any particular theory, a microwave plasma generates a high density of hydrogen radicals, which can etch away any amorphous carbon phase material, leaving a higher quality carbon allotrope at a lower process temperature.

This deposition process can be carried out with the workpiece at a relatively low temperature, e.g., 25-800° C. Consequently, the pedestal 102 supporting the workpiece 10 need not to be heated. In some implementations, the pedestal 102 is cooled, e.g., by the coolant flowing through passages 103c. In some implementations, a coolant gas, e.g., helium, can flow between the pedestal 102 and the backside of the workpiece 10 to improve heat transfer between the workpiece 10 and the pedestal 102. The workpiece 10 can be electrostatically clamped to the pedestal 102, e.g., by application of a chucking voltage to an electrode embedded in the pedestal.

The deposition process can proceed, e.g., for 15-1800 seconds.

While particular implementations have been described, other and further implementations may be devised without departing from the basic scope of this disclosure. For example
- Rather than a single workpiece support, the chamber 101 can include multiple supports so that multiple workpieces can be processed simultaneously.
- Although the reactor is described as including a gas distribution plate, in some implementations the gas distribution plate is omitted; process gas can be supplied solely through the gas distribution ring 150.
- Instead of being incorporated into the ceiling, the gas distribution plate could hang below the ceiling as a separate showerhead.

The scope of the invention is defined by the claims that follow.

## Claims

1. A plasma reactor (100) for processing a workpiece (10) comprising:
a chamber (101) having a dielectric window (108);
a workpiece support (102) configured to hold a workpiece in the chamber;
a rotary coupling (118) comprising a stationary stage (118-1) configured to be coupled to a microwave source (132) and a rotatable stage (118-2) having an axis of rotation;
a microwave antenna (114) overlying the dielectric window of the chamber, the microwave antenna including at least one conduit coupled to the rotatable stage;
a rotary actuator (130) configured to rotate the microwave antenna;
a first vacuum pump (158) coupled to a circular conduit; and
a process gas distributor (140) including a gas distribution ring (150) surrounding the workpiece support (102), the gas distribution ring including a cylindrical chamber liner separating the circular conduit from the chamber and a plurality of apertures (156) extending radially through the liner to connect the conduit to the chamber;
wherein the circular conduit comprises a first arc (150a) coupled to a process gas supply (146), a second arc (150b) coupled to the first vacuum pump (158), and a barrier (152c) configured to prevent direct fluid flow between the first arc and the second arc.

2. The plasma reactor (100) of claim 1, wherein the plurality of apertures are distributed with uniform angular spacing around the cylindrical chamber liner.

3. The plasma reactor (100) of claim 1, wherein the circular conduit extends uninterrupted around the cylindrical chamber liner.

4. The plasma reactor (100) of claim 1, wherein the first arc (150a) and the second arc (150b) have substantially the same arc length.

5. The plasma reactor (100) of claim 1, wherein the plurality of the apertures (156) are positioned to be below a plane defined by a top surface of the workpiece support (102).

6. The plasma reactor (100) of claim 1, comprising a gas distribution plate (142) on a ceiling of the chamber.

7. The plasma reactor (100) of claim 6, wherein the dielectric window (108) provides the gas distribution plate (142).

8. The plasma reactor (100) of claim 1, wherein the gas distribution ring (150) has between six and one-hundred apertures.

9. The plasma reactor (100) of claim 1, further comprising:
a first gas supply configured to provide a hydrocarbon gas;
a second gas supply configured to provide an inert gas;
a second vacuum pump (105) coupled to the chamber to evacuate the chamber; and
a controller configured to operate the microwave source, the process gas distributor (140) and the second vacuum pump (105) to deposit a carbon allotrope on the workpiece;
wherein the process gas distributor (140) is configured to deliver the hydrocarbon gas and the inert gas to the chamber.

10. The plasma reactor (100) of claim 9, wherein the controller is configured to cause the first and second gas supply to establish a total pressure of 20mTorr to 20Torr.

11. The plasma reactor (100) of claim 9, wherein the controller is configured to cause the first and second gas supply to establish a relative flow rate of hydrocarbon gas to inert gas of 0.05 to 1.

12. A method of processing a workpiece comprising:
placing a workpiece (10) on a workpiece support (102) in a chamber (101);
evacuating the chamber (101) with a second vacuum pump (105);
supplying a hydrocarbon gas through a plurality of apertures (156) that extend radially through a cylindrical chamber liner of a gas distribution ring (150) that surrounds the workpiece support, the liner separating a circular conduit from the chamber and a plurality of apertures extending radially through the liner to connect the conduit to the chamber, wherein the circular conduit comprises a first arc (150a) coupled to a process gas supply (146), a second arc (150b) coupled to a first vacuum pump (158), and a barrier (152c) preventing direct fluid flow between the first arc and second arc;
supplying an inert gas into the chamber; and
applying microwave radiation through a dielectric window (108) from a microwave antenna (114) while rotating the antenna so as to generate a plasma in the chamber and deposit a carbon allotrope on the workpiece.

## Patentansprüche

1. Plasmareaktor (100) zum Bearbeiten eines Werkstücks (10), umfassend:
eine Kammer (101), die ein dielektrisches Fenster (108) aufweist;
eine Werkstückauflage (102), die zum Halten eines Werkstücks in der Kammer konfiguriert ist;
eine Drehkopplung (118), umfassend eine stationäre Stufe (118-1), die dazu konfiguriert ist, mit einer Mikrowellenquelle (132) und einer drehbaren Stufe (118-2), die eine Drehachse aufweist, gekoppelt zu werden;
eine Mikrowellenantenne (114), die auf dem dielektrischen Fenster der Kammer aufliegt, wobei die Mikrowellenantenne mindestens eine Leitung aufweist, die mit der drehbaren Stufe gekoppelt ist;
einen Drehaktuator (130), der zum Drehen der Mikrowellenantenne konfiguriert ist;
eine erste Vakuumpumpe (158), die mit einer kreisförmigen Leitung gekoppelt ist; und
einen Prozessgasverteiler (140), der einen Gasverteilungsring (150) aufweist, der die Werkstückauflage (102) umgibt, wobei der Gasverteilungsring eine zylindrische Kammerauskleidung, die die kreisförmige Leitung von der Kammer trennt, und eine Vielzahl von Öffnungen (156) aufweist, die sich radial durch die Auskleidung erstrecken, sodass sie die Leitung mit der Kammer verbinden;
wobei die kreisförmige Leitung einen ersten Bogen (150a), der mit einer Prozessgasversorgung (146) gekoppelt ist, einen zweiten Bogen (150b), der mit der ersten Vakuumpumpe (158) gekoppelt ist, und eine Barriere (152c) umfasst, die so konfiguriert ist, dass sie einen direkten Fluidstrom zwischen dem ersten Bogen und dem zweiten Bogen verhindert.

2. Plasmareaktor (100) nach Anspruch 1, wobei die Vielzahl von Öffnungen mit einem gleichmäßigen Winkelabstand um die zylindrische Kammerauskleidung herum verteilt sind.

3. Plasmareaktor (100) nach Anspruch 1, wobei sich die kreisförmige Leitung ununterbrochen um die zylindrische Kammerauskleidung herum erstreckt.

4. Plasmareaktor (100) nach Anspruch 1, wobei der erste Bogen (150a) und der zweite Bogen (150b) im Wesentlichen die gleiche Bogenlänge aufweisen.

5. Plasmareaktor (100) nach Anspruch 1, wobei die Vielzahl von Öffnungen (156) so positioniert ist, dass sie unterhalb einer Ebene liegen, die durch eine obere Oberfläche der Werkstückauflage (102) definiert ist.

6. Plasmareaktor (100) nach Anspruch 1, umfassend eine Gasverteilungsplatte (142) an einer Decke der Kammer.

7. Plasmareaktor (100) nach Anspruch 6, wobei das dielektrische Fenster (108) die Gasverteilungsplatte (142) bereitstellt.

8. Plasmareaktor (100) nach Anspruch 1, wobei der Gasverteilungsring (150) zwischen sechs und einhundert Öffnungen aufweist.

9. Plasmareaktor (100) nach Anspruch 1, ferner umfassend:
eine erste Gasversorgung, die zum Bereitstellen eines Kohlenwasserstoffgases konfiguriert ist;
eine zweite Gasversorgung, die zum Bereitstellen eines Inertgases konfiguriert ist;
eine zweite Vakuumpumpe (105), die zum Evakuieren der Kammer mit der Kammer gekoppelt ist; und
eine Steuerung, die zum Betreiben der Mikrowellenquelle, des Prozessgasverteilers (140) und der zweiten Vakuumpumpe (105) zum Abscheiden eines Kohlenstoffallotrops auf dem Werkstück konfiguriert ist;
wobei der Prozessgasverteiler (140) zum Abgeben des Kohlenwasserstoffgases und des Inertgases an die Kammer konfiguriert ist.

10. Plasmareaktor (100) nach Anspruch 9, wobei die Steuerung konfiguriert ist zum Bewirken, dass die erste und die zweite Gasversorgung einen Gesamtdruck von 20 mTorr bis 20 Torr herstellen.

11. Plasmareaktor (100) nach Anspruch 9, wobei die Steuerung konfiguriert ist zum Bewirken, dass die erste und die zweite Gasversorgung eine relative Durchflussrate von Kohlenwasserstoffgas zu Inertgas von 0,05 bis 1 herstellen.

12. Verfahren zum Bearbeiten eines Werkstücks, umfassend:
Platzieren eines Werkstücks (10) auf einer Werkstückauflage (102) in einer Kammer (101);
Evakuieren der Kammer (101) mit einer zweiten Vakuumpumpe (105);
Zuführen eines Kohlenwasserstoffgases durch eine Vielzahl von Öffnungen (156), die sich radial durch eine zylindrische Kammerauskleidung eines Gasverteilungsrings (150) erstrecken, der die Werkstückauflage umgibt, wobei die Auskleidung eine kreisförmige Leitung von der Kammer und einer Vielzahl von Öffnungen, die sich radial durch die Auskleidung erstrecken, zum Verbinden der Leitung mit der Kammer trennt, wobei die kreisförmige Leitung einen ersten Bogen (150a), der mit einer Prozessgasversorgung (146) gekoppelt ist, einen zweiten Bogen (150b), der mit einer ersten Vakuumpumpe (158) gekoppelt ist, und eine Barriere (152c) umfasst, die einen direkten Fluidstrom zwischen dem ersten Bogen und dem zweiten Bogen verhindert;
Zuführen eines Inertgases in die Kammer; und
Anwenden von Mikrowellenstrahlung durch ein dielektrisches Fenster (108) von einer Mikrowellenantenne (114) während der Drehung der Antenne, sodass ein Plasma in der Kammer erzeugt wird und ein Kohlenstoffallotrop auf dem Werkstück abgeschieden wird.

## Revendications

1. Réacteur à plasma (100) pour traitement d'une pièce (10) comprenant :
une chambre (101) présentant une fenêtre diélectrique (108) ;
un support de pièce (102) configuré pour maintenir une pièce dans la chambre ;
un couplage rotatif (118) comprenant un étage fixe (118-1) configuré pour être couplé à une source de micro-ondes (132) et un étage rotatif (118-2) présentant un axe de rotation ;
une antenne à micro-ondes (114) chevauchant la fenêtre diélectrique de la chambre, l'antenne à micro-ondes comportant au moins un conduit couplé à l'étage rotatif ;
un actionneur rotatif (130) configuré pour faire tourner l'antenne à micro-ondes ;
une première pompe à vide (158) couplée à un conduit circulaire ; et
un distributeur de gaz de traitement (140) comportant un anneau de distribution de gaz (150) entourant le support de pièce (102), l'anneau de distribution de gaz comportant un revêtement de chambre cylindrique séparant le conduit circulaire de la chambre et une pluralité d'ouvertures (156) s'étendant radialement à travers le revêtement pour raccorder le conduit à la chambre ;
dans lequel le conduit circulaire comprend un premier arc (150a) couplé à une alimentation en gaz de traitement (146), un deuxième arc (150b) couplé à la première pompe à vide (158), et une barrière (152c) configurée pour empêcher un écoulement de fluide direct entre le premier arc et le deuxième arc.

2. Réacteur à plasma (100) selon la revendication 1, dans lequel la pluralité d'ouvertures sont réparties avec un espacement angulaire uniforme autour du revêtement de chambre cylindrique.

3. Réacteur à plasma (100) selon la revendication 1, dans lequel le conduit circulaire s'étend de façon ininterrompue autour du revêtement de chambre cylindrique.

4. Réacteur à plasma (100) selon la revendication 1, dans lequel le premier arc (150a) et le deuxième arc (150b) présentent sensiblement la même longueur d'arc.

5. Réacteur à plasma (100) selon la revendication 1, dans lequel la pluralité d'ouvertures (156) sont positionnées pour se trouver sous un plan défini par une surface supérieure du support de pièce (102).

6. Réacteur à plasma (100) selon la revendication 1, comprenant une plaque de distribution de gaz (142) sur un plafond de la chambre.

7. Réacteur à plasma (100) selon la revendication 6, dans lequel la fenêtre diélectrique (108) approvisionne la plaque de distribution de gaz (142).

8. Réacteur à plasma (100) selon la revendication 1, dans lequel l'anneau de distribution de gaz (150) comporte entre six et cent ouvertures.

9. Réacteur à plasma (100) selon la revendication 1, comprenant en outre :
une première alimentation en gaz configurée pour fournir un gaz d'hydrocarbures ;
une deuxième alimentation en gaz configurée pour fournir un gaz inerte ;
une deuxième pompe à vide (105) couplée à la chambre pour évacuer la chambre ; et
un dispositif de commande configuré pour faire fonctionner la source de micro-ondes, le distributeur de gaz de traitement (140) et la deuxième pompe à vide (105) afin de déposer un allotrope de carbone sur la pièce ;
dans lequel le distributeur de gaz de traitement (140) est configuré pour distribuer le gaz d'hydrocarbures et le gaz inerte à la chambre.

10. Réacteur à plasma (100) selon la revendication 9, dans lequel le dispositif de commande est configuré pour faire établir aux première et deuxième alimentations en gaz une pression totale de 20 mTorr à 20 Torr.

11. Réacteur à plasma (100) selon la revendication 9, dans lequel le dispositif de commande est configuré pour faire établir aux première et deuxième alimentations en gaz un débit relatif de gaz d'hydrocarbures sur gaz inerte de 0,05 à 1.

12. Procédé de traitement d'une pièce comprenant :
mettre en place une pièce (10) sur un support de pièce (102) dans une chambre (101) ;
vider la chambre (101) avec une deuxième pompe à vide (105) ;
apporter un gaz d'hydrocarbures à travers une pluralité d'ouvertures (156) qui s'étendent radialement à travers un revêtement de chambre cylindrique d'un anneau de distribution de gaz (150) qui entoure le support de pièce, le revêtement séparant un conduit circulaire de la chambre et une pluralité d'ouvertures s'étendant radialement à travers le revêtement pour raccorder le conduit à la chambre, dans lequel le conduit circulaire comprend un premier arc (150a) couplé à une alimentation en gaz de traitement (146), un deuxième arc (150b) couplé à une première pompe à vide (158) et une barrière (152c) empêchant un écoulement de fluide direct entre le premier arc et le deuxième arc ;
apporter un gaz inerte dans la chambre ; et
appliquer un rayonnement à micro-ondes à travers une fenêtre diélectrique (108) depuis une antenne à micro-ondes (114) tout en faisant tourner l'antenne de manière à générer un plasma dans la chambre et à déposer un allotrope de carbone sur la pièce.
